# EUROPEAN PATENT APPLICATION

(11) **EP 4 546 205 A1**
(43) Date of publication of application: **30.04.2025**
(21) Application number: 23934297.5
(22) Date of filing: 08.11.2023
(51) Int. Cl.: G06F 30/394

(54) **WIRING METHOD AND APPARATUS FOR CHIP LAYOUT, AND DEVICE AND STORAGE MEDIUM**

(30) Priority: 07.09.2023 CN 202311160318
(71) Applicant: TENCENT TECHNOLOGY (SHENZHEN) COMPANY LIMITED, Shenzhen, Guangdong 518057 (CN)
(72) Inventor: XU, Xiong, Shenzhen, Guangdong 518057 (CN); YE, Kai, Shenzhen, Guangdong 518057 (CN); HUAI, Sainan, Shenzhen, Guangdong 518057 (CN); ZHANG, Shengyu, Shenzhen, Guangdong 518057 (CN); ZHENG, Yicong, Shenzhen, Guangdong 518057 (CN)
(74) Representative: Reddie & Grose LLP
(86) International application number: PCT/CN2023/130560
(87) International publication number: WO 2025/050502

(57) **Abstract**

A method and an apparatus for routing on a chip layout, a device, and a storage medium, which relate to the field of quantum technologies. The method includes: obtaining (710) a route of a wire extending from a first routing port of the chip layout to a second routing port of the chip layout, where: the route comprises tangent segment(s) and circular arc(s) that are alternately connected; for each tangent segment, a straight line comprising said tangent segment is tangent to each circle comprising a circular arc connected to said tangent segment; and for each circular arc, a respective vertex of the chip layout serves as a center of said circular arc, the vertex is of a polygon representing a chip component in the chip layout, and said circular arc forms a detour between the first routing port and the second routing port for avoidance of the chip component; determining (720) a target circular arc among the at least one circular arc, wherein the target circular arc is a circular arc introducing a loop into the route, and the circular arc introducing the loop into the route refers to that a central angle of the circular arc is greater than a threshold; and replacing (730), in the route, the target circular arc with a new sub-route to adjust the route of the wire. The method improves accuracy of routing.

## Description

The present disclosure claims priority to Chinese Patent Application No. 202311160318.1, entitled "METHOD AND APPARATUS FOR ROUTING ON CHIP LAYOUT, DEVICE, AND STORAGE MEDIUM" and filed on September 07, 2023.

### FIELD OF THE TECHNOLOGY

Embodiments of the present disclosure relate to the field of quantum technologies, and in particular, to a method and an apparatus for routing on a chip layout, a device, and a storage medium.

### BACKGROUND OF THE DISCLOSURE

In the field of quantum technologies, a chip layout generally needs to be designed to prepare a corresponding quantum chip. Arrangements of chip components, connections among the chip components, and the like, may be designed on a basis of the chip layout.

In conventional technology, routing is performed to connect chip components in a chip layout on requirement. Generally, a chip component for which a route of a wire is detoured may be first determined according to a source port and a destination port of the route, and a circular-arc sub-route is configured to implement the detour for avoidance of such chip component.

In conventional technology, the circular-arc sub-route may introduce a loop into a route of a wire during the routing. That is, a central angle of the circular-arc sub-route that is configured for avoidance of a chip component is such large that the circular-arc sub-route overlaps with a route of another wire. In such case, the final routing design is inappropriate.

### SUMMARY

Embodiments of the present disclosure provide a method and an apparatus for routing on a chip layout, a device, and a storage medium, which can improve accuracy of routing. The technical solutions are as follows.

According to an aspect of the embodiments of the present disclosure, a method for routing on a chip layout is provided. The method is performed by a computer device, and the method includes: obtaining a route of a wire extending from a first routing port of the chip layout to a second routing port of the chip layout, where: the route comprises at least one tangent segment and at least one circular arc that are alternately connected; for each of the at least one tangent segment, a straight line comprising said tangent segment is tangent to each circle comprising a circular arc, of the at least one circular arc, connected to said tangent segment; and for each circular arc of the at least one circuit arcs, a respective vertex of the chip layout serves as a center of said circular arc, the vertex is of a polygon representing a chip component in the chip layout, and said circular arc forms a detour between the first routing port and the second routing port for avoidance of the chip component; determining a target circular arc among the at least one circular arc, wherein the target circular arc is a circular arc introducing a loop into the route, and the circular arc introducing the loop into the route refers to that a central angle of the circular arc is greater than a threshold; and replacing, in the route, the target circular arc with a new sub-route to adjust the route of the wire.

According to an aspect of the embodiments of the present disclosure, a chip is provided. The chip is manufactured based on a chip layout with routing obtained through the foregoing method for routing on the chip layout.

According to an aspect of the embodiments of the present disclosure, an apparatus for routing on a chip layout is provided. The apparatus includes: a routing determining module, configured to obtain a route of a wire extending from a first routing port of the chip layout to a second routing port of the chip layout, where: the route comprises at least one tangent segment and at least one circular arc that are alternately connected; for each of the at least one tangent segment, a straight line comprising said tangent segment is tangent to each circle comprising a circular arc, of the at least one circular arc, connected said tangent segment; and for each circular arc of the at least one circuit arcs, a respective vertex of the chip layout serves as a center of said circular arc, the vertex is of a polygon representing a chip component in the chip layout, and said circular arc forms a detour between the first routing port and the second routing port for avoidance of the chip component; an arc determining module, configured to determine a target circular arc among the at least one circular arc, wherein the target circular arc is a circular arc introducing a loop into the route, and the circular arc introducing the loop into the route refers to that a central angle of the circular arc is greater than a threshold; and; and a routing adjusting module, configured to replace, in the route, the target circular arc with a new sub-route to adjust the route of the wire.

According to an aspect of the embodiments of the present disclosure, a computer device is provided. The computer device includes a processor and a memory. The memory stores a computer program. The processor is configured to perform the computer program to implement the foregoing method for routing on the chip layout.

According to an aspect of the embodiments of the present disclosure, a computer-readable storage medium is provided. The computer-readable storage medium stores a computer program. The computer program is loaded and executed by a processor to implement the foregoing method for routing on the chip layout.

According to an aspect of the embodiments of the present disclosure, a computer program product is provided. The computer program product includes a computer program. The computer program is loaded and executed by a processor to implement the method for routing on the chip layout.

The technical solutions provided in embodiments of the present disclosure have the following beneficial effects:
During the routing, the circular arc having the central angle greater than the threshold is recognized from the circular arc(s) and is then removed. Hence, the adjusted route would not include the circular arc having the central angle greater than the threshold. That is, all circular arcs introducing a loop into the route are removed and only circular arcs introducing no loop into route are reserved. Routes of wires that are determined during the routing due are prevented from overlapping with each other due to the loop, and a final design of the routes on the chip layout is more reasonable and accurate.

### BRIEF DESCRIPTION OF THE DRAWINGS

FIG. 1 is a schematic diagram of a topological route in conventional technology.
FIG. 2 is a schematic diagram of routing in conventional technology.
FIG. 3 is a schematic diagram of route looping in conventional technology.
FIG. 4 is a schematic diagram of comparison between a topological route and an actual route in conventional technology.
FIG. 5 is a schematic diagram of another route looping in conventional technology.
FIG. 6 is a schematic diagram of a process of removing route looping according to an embodiment of the present disclosure.
FIG. 7 is a flowchart of a method for routing on a chip layout according to an embodiment of the present disclosure.
FIG. 8 is a schematic diagram of a target circular arc according to an embodiment of the present disclosure.
FIG. 9 is a flowchart of a method for routing on a chip layout according to another embodiment of the present disclosure.
FIG. 10 is a schematic diagram of a target circular arc according to another embodiment of the present disclosure.
FIG. 11 is a flowchart of a method for routing on a chip layout according to another embodiment of the present disclosure.
FIG. 12 is a flowchart of a method for routing on a chip layout according to another embodiment of the present disclosure.
FIG. 13 is a flowchart of a method for routing on a chip layout according to another embodiment of the present disclosure.
FIG. 14 is a flowchart of a method for routing on a chip layout according to another embodiment of the present disclosure.
FIG. 15 is a schematic diagram of a process of removing route looping according to an embodiment of the present disclosure.
FIG. 16 is a block diagram of an apparatus for routing on a chip layout according to an embodiment of the present disclosure.
FIG. 17 is a block diagram of an apparatus for routing on a chip layout according to another embodiment of the present disclosure.
FIG. 18 is a structural block diagram of a computer device according to an embodiment of the present disclosure.

### DESCRIPTION OF EMBODIMENTS

To make objectives, technical solutions, and advantages of the present disclosure clearer, implementations of the present disclosure are further described below in detail with reference to the accompanying drawings.

Before embodiments of the present disclosure are introduced and described, some terms involved in the present disclosure are first explained and described.
1. Superconducting quantum chip: It is a central processing unit of a superconducting quantum computer. A quantum computer is a machine that performs calculation according to the principle of quantum mechanics. Based on the superposition principle of quantum mechanics and quantum entanglement, the quantum computer has a strong parallel processing capability and can resolve some problems that are difficult to calculate by a classical computer. Zero-resistance characteristics of superconducting qubits and a manufacturing process close to that of integrated circuits enable a quantum computing system built by using the superconducting qubits to be one of the most promising systems for practical quantum computing.
2. Electronic design automation (EDA): It is a design manner in the electronic field. It means using computer software (aided design software) to complete design work in the electronic field and achieve automation of design, and includes, for example, function design, function verification, and layout and routing of integrated circuit chips. Software tools used herein are collectively referred to as EDA tools.
3. Automatic routing: It means automatic arrangement of lines in a circuit and chip design by using software and connecting components according to rules and requirements. The automatic routing is mainly used as a link in large-scale and ultra-large-scale integrated circuit design and is usually performed after arrangement of layout is completed.
4. Layout: It is also referred to as a circuit layout, and is a design drawing describing arrangement, placement, and connection of the components in the circuit. The layout is description of a physical situation of a real circuit in a form of planar geometric shapes. Design of the layout needs to conform to conditions of manufacturing processes, time sequences, areas, power consumption, and the like. A layout design document includes information about shapes, area, and positions of all hardware units on the chip.
5. Component: It is a collective term of elements and devices, and represents electronic components and constituent elements in circuits, such as resistors, capacitors, and inductors.
6. Co-planar waveguide (CPW): It is a microwave planar transmission line with superior performance and convenient processing and is configured to transmit microwave signals. A co-planar waveguide technology is heavily used in the superconducting quantum chips.
7. Radius of curvature: It is a reciprocal of a curvature, and is represented by R. For a curve, the radius of curvature is equal to a radius of a circular arc closest to a curve of a point.
8. Microwave: It is an electromagnetic wave with a wavelength between infrared and a radio wave, and with a frequency ranging from 300 MHz to 300 GHz, which is higher than a radio frequency, and is also referred to as an ultra-high frequency electromagnetic wave. The microwave is used in a radar, a wireless network, and a sensor. In superconducting quantum, the microwave located in a resonant cavity can carry and store a quantum state, so that the microwave is used for quantum information processing.
9. Phase: It is a measure that describes a change in a signal waveform, and a unit is a degree (deg) or a radian (rad).
10. Topology: Topology is a discipline that studies topological spaces. It is developed from geometry and set theory. It mainly studies properties of geometric figures or spaces that remain unchanged after continuous changes in shape. Research includes space, dimension, transformation, and other concepts. The topology only considers a positional relationship between objects rather than a shape or a size. A topological route is a routing manner based on a topological structure and a topological network.
11. Resonance: It is fully referred to as simple harmonic vibration and is also referred to as resonance in physics. In electronics, when an input impedance and an output impedance of a circuit are almost 0 and a transfer function is close to 1, impedances or admittances of circuit elements cancel each other out, and the circuit oscillates at a specific frequency (a resonance frequency), causing the circuit to generate a higher current and a higher voltage than an input current and voltage. This phenomenon is referred to as electrical resonance or circuit resonance. In quantum mechanics, resonance of particles is similar to a situation in classical physics.

In conventional technology, a topological route algorithm is another type of routing algorithm different from a grid routing algorithm. A process of the topological route may be roughly decomposed into the following stages: (1) Mincut (a minimum cut algorithm) is performed on a line arrangement in which placement has been completed (components have been placed), to divide the arrangement into independent chip arrangements. (2) Multi-layer planning is performed on an individual chip, and cross-layer auxiliary components such as through holes are introduced, to divide the individual chip into independent layers of lines. Generally, positions of the components are fixed, and positions of components on different layers do not intersect. (3) Triangulation is performed on components on each layer of lines, and the topological algorithm is introduced to implement topological directions between a plurality of pairs of routing ports. The topological direction is a line pair connecting a source port to a destination port and bypassing an existing component. The routing port includes the source port and the destination port. The source port is a pin (a control/read pin of a bit), and the destination port is a pad (a pad around the chip). A routing process is to find a proper line to connect the pin to the pad. The routing port also belongs to components on the chip layout, equivalent to two types of special devices. The pin and the pad need to be determined first, and then the routing process is to find a line to connect the pin and the pad. In addition, the line does not intersect with another device, and a route is as short as possible. In other words, polygons abstracted from components on different layers are merged on a same layer (different components generally do not intersect with each other), and then Delaunay Triangulation (DT) is performed on all the polygons. After the Delaunay Triangulation, a large number of connection lines between points of the polygons corresponding to the components are obtained. (4) Corresponding final routing is generated for each group of a topological route. A requirement on the routing is to bypass the components. Therefore, a specific distance is obtained starting from an endpoint of the polygon along the connection lines obtained through the triangulation, and a path required for the routing can be determined. In some embodiments, the triangulation is implemented through a Constrained Delaunay Triangulation (CDT) algorithm based on the DT algorithm, that is, some limiting edges are added based on the DT. An objective of the DT algorithm is to segment a planar point set to form triangles, and a circumcircle of each triangle cannot include a fixed point of another triangle.

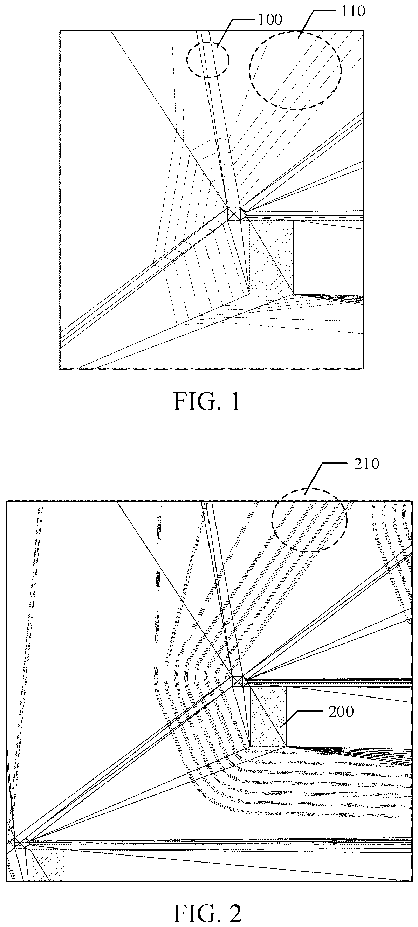

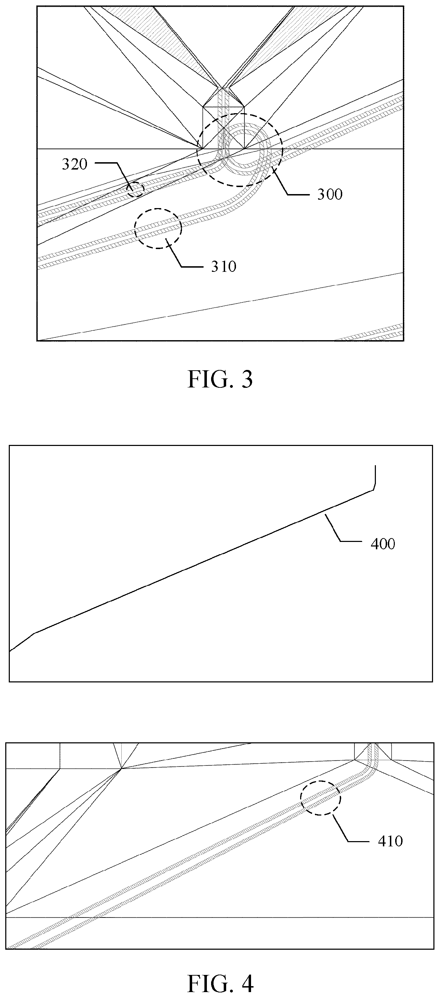

However, in conventional technology, when the topological route is converted into the routing, due to some blind spots in the algorithm, a line in the converted routing may introduce the loop a circle. FIG. 1 shows an algorithm output of the topological route. A plurality of initial signal lines 110 formed by initial path points pass through a triangulated grid 100 formed by components. FIG. 2 shows normal routing. A plurality of lines 210 that are normally arranged do not intersect or overlap with each other. In some embodiments, a triangulation line and a square obstacle (a component that needs to be avoided using a detour) that needs to be avoided using a detour are determined according to components and routing ports on a chip layout, and a proper distance is selected from a fixed point of the obstacle along the triangulation line based on a spacing. The spacing herein is a shortest spacing specified in advance between different lines, and a shortest spacing between the lines and the components. FIG. 2 shows a plurality of topological paths that are finally implemented when a plurality of lines needs to bypass a same obstacle, and different distances are respectively selected. An intersection point between the triangulation line and the initial signal line is a topological path point of different lines (a plurality of lines needs to be arranged at the same time) found in this operation. FIG. 3 shows abnormal routing. Arranged lines 310 introduce the loop (a circle) at a position 300, causing the arranged lines 310 and arranged lines 320 to intersect at the position 300.

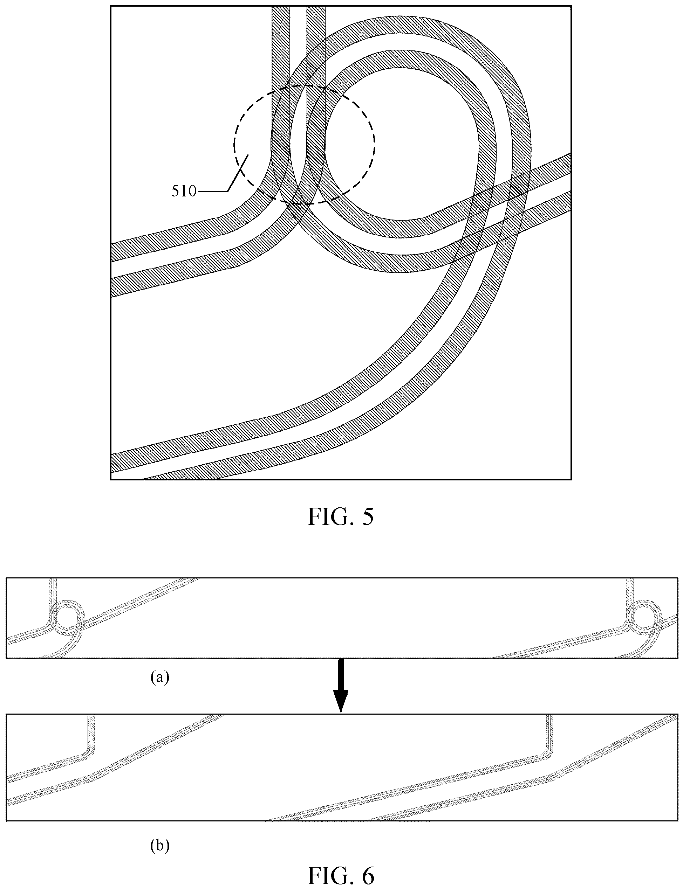

Specifically, in the routing algorithm in conventional technology, path points around each signal line that needs to be arranged are first determined. Then the path points are traversed to find proper path points. Triangulation endpoints (a triangulation endpoint is a vertex of a series of line segments obtained through triangulation performed on a plurality of all inputted polygons that are abstracted (from components) on the chip layout that need to be avoided using a detour are determined according to specific situations of triangulation endpoints near the path points. That is, centers, radius, and initial points and terminal points of a series of circular arcs in a final routing path are determined. Finally, the circular arcs are connected through tangents to form final signal lines. The triangulation endpoints are vertexes in embodiments of the present disclosure. The triangulation endpoints and the vertexes have the same meaning, and both indicate vertexes of the polygons corresponding to the components. As shown in FIG. 4, a topological route 400 includes a plurality of path points obtained through the topological algorithm. In some embodiments, routing 410 is determined according to the topological route 400. In some embodiments, the routing may introduce the loop a circle. As shown in FIG. 5, one of two arranged CPW lines introduces the loop a circle, and intersects with the other CPW line at a position 510. A consequence caused by routing looping is apparent in both FIG. 3 and FIG. 5. A signal of the CPW is interrupted due to a routing error, and adjacent routing is interrupted due to looping routing. Therefore, this defect from the topological route to the routing needs to be resolved.

The solutions provided in embodiments of the present disclosure provide a general supplementary algorithm for resolving such looping problem through in-depth analysis of a rendering algorithm from the topological route to the routing. As shown in FIG. 6, (a) shows a situation in which lines intersect due to routing looping, (b) shows lines normally arranged by avoiding the routing looping. The present disclosure implements a process from (a) to (b). In the present disclosure, an algorithm that can automatically recognize and properly avoid route looping of signal lines during routing is researched and developed based on the a topological route, to prevent the automatically arranged signal lines from intersecting and prevent a distance between the signal lines from being excessively short due to the foregoing reason, so that an automatic routing requirement of a superconducting quantum chip is satisfied. Therefore, the present disclosure has the following innovations: EDA automatic routing for superconducting quantum chips, automatic recognition of route looping of signal lines, and intelligently selecting proper routing paths according to different route looping.

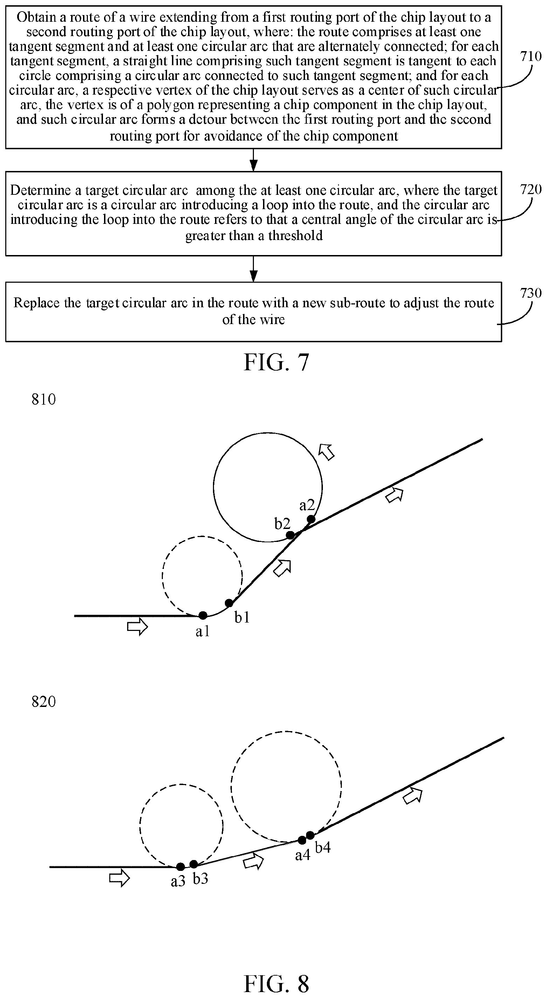

FIG. 7 is a flowchart of a method for routing on a chip layout according to an embodiment of the present disclosure. The method may be performed by a computer device. The computer device may be any electronic device having computing and storage capabilities, such as a personal computer (PC), a tablet computer, or a server. For example, the computer device may run a computer program configured to perform the method, and the method for routing on a chip layout provided in an embodiment is implemented through the computer program. As shown in FIG. 7, the method may include at least one of the following steps 710 to 730.

In step 710, a route of a wire extending from a first routing port of the chip layout to a second routing port of the chip layout is obtained. The route comprises at least one tangent segment and at least one circular arc that are alternately connected. For each tangent segment, a straight line comprising such tangent segment is tangent to each circle comprising a circular arc, of the at least one circular arc, connected to such tangent segment. For each circular arc, a respective vertex of the chip layout serves as a center of such circular arc, the vertex is of a polygon representing a chip component in the chip layout, and such circular arc forms a detour between the first routing port and the second routing port for avoidance of the chip component.

A chip layout is a designed graph which describes a layout, placement, and connection of chip components in a chip circuit. The chip layout describes a physical arrangement of a real circuit using planar geometric shapes. The chip layout may be a chip layout of a quantum chip, for example, may be a chip layout of a superconducting quantum chip. The co-planar waveguide technology is greatly used in superconducting quantum chips for transmitting microwave signals. A layout design document of the chip layout includes information about shapes, areas, positions, and the like, of all hardware units in the chip. Through automatic routing, information about route(s) that connect points in the chip layout may be added into the layout design document, and thereby the layout design document carrying routing information is generated. The routing information may include positional information of the chip components and may further include positional information of connections (e.g., wires) among the chip components.

In embodiments of the present disclosure including the embodiments of both the claims and the specification (hereinafter referred to as "all embodiments of the present disclosure"), the first routing port and the second routing port may be considered as a pair of routing ports. The first routing port may be considered as a start position of the route, and the second routing port may be considered as an end position of the route. Generally, in a chip layout including a plurality of components, and a plurality of pairs of routing ports may to be included. A quantity of routing ports is not limited in an embodiment of the present disclosure, and a quantity of routing ports to be used in the routing is also not limited in an embodiment of the present disclosure. An example in which routing is performed by using one pair of routing ports is only used as an example in an embodiment of the present disclosure, and routing of other pairs of routing ports may refer to this embodiment of the present disclosure. When connection between each pair of routing ports on the chip layout is completed, routing of the chip layout is considered to be completed. The ports that need to be connected may be set in advance by developers or determined in advance according to an algorithm. In all embodiments of the present disclosure, routing may be performed after the routing ports that need to be connected are determined.

The first routing port is a chip component or a part of the chip component. In all embodiments of the present disclosure, the first routing port may be a special chip component, and the chip component is a start of routing. Alternatively, the first routing port may be a pin of a chip component. For example, the first routing port is a pin (a control/reading pin of a bit). In all embodiments of the present disclosure, different components on the chip layout and different pins in the components have different features. Assuming that component a and component b need to be connected, the component a is first found, then a pin that meets a pin feature is found from pins of the component a, and the pin is used as the first routing port.

The second routing port is a chip component or a part of the chip component. In all embodiments of the present disclosure, the second routing port is a special chip component, and the chip component is an end of routing. In all embodiments of the present disclosure, the second routing port may be a pad of a chip component. For example, the second routing port is a pad (a pad around the chip). In all embodiments of the present disclosure, a routing process may be configured to find a proper line connecting the pin to the pad. Assuming that component a and component b need to be connected, after a pin that meets a pin feature is found from pins of component a, a pad of the component b is found, and the pad is used as the second routing port.

In all embodiments of the present disclosure, there may be a plurality of components between the first routing port and the second routing port. Therefore, the components on an intermediate path need to be avoided using a detour. As shown in FIG. 2, a rectangle 200 represents a component on the chip layout. Generally, during designing of the chip layout, the components are patterned. To be specific, the components correspond to various patterns on the chip layout. The rectangle 200 shown in FIG. 2 is a result of patterning components. Different components may correspond to different patterns, and different patterns may have different numbers of vertexes. During routing, which vertex of the rectangle 200 to avoid needs to be considered. In all embodiments of the present disclosure, during routing, circular-arc sub-routes may be arranged at the vertex that needs to be avoided to make a detour around the component. Therefore, when a plurality of components needs to be avoided, a plurality of vertexes needs to be avoided using detours, that is, there are a plurality of circular arcs. In all embodiments of the present disclosure, the vertex may be an endpoint, namely, a triangulation endpoint, of a triangulation line obtained through constrained Delaunay Triangulation performed on the components on the chip layout. For example, a vertex of a chip component is a triangulation endpoint and is a vertex of a polygon representing the chip component. The polygon representing the chip component is a polygon configured to characterize the real chip component to facilitate computation in a level of algorithm. For example, the polygon approximates the chip component in size and shape. The real chip components and the polygons in the chip layout may be in one-to-one correspondence.

In all embodiments of the present disclosure, the route in step 710 may be an initial version of the route, or maybe an adjusted version of the routing, which is not limited in the present disclosure. The initial version of the route is a route that is determined according to the first routing port and the second routing port for the first time and has not been adjusted. In all embodiments of the present disclosure, the initial routing may include at least one circular arc using the vertex as a center and at least two tangent segments connected to the circular arc. For example, when there is only one component that needs to be avoided using a detour, the circular arc corresponding to the vertex of the component is determined. A connection line between a start position of the circular arc and the first routing port is tangent to the circular arc, and a connection line between an end position of the circular arc and the second routing port is tangent to the circular arc. Certainly, a quantity of components that need to be avoided using a detour is not limited in embodiments of the present disclosure. The quantity of components that need to be avoided using a detour is positively correlated with a quantity of circular arcs in the route. When more components need to be avoided using a detour, the quantity of the circular arc in the routing is correspondingly increased.

In addition, "alternately connected" in an embodiment of the present disclosure means that the circular arc(s) and the tangent segment(s) are alternately connected. For example, each circular arc is connected to a preceding tangent segment and a following tangent segment, and each tangent segment is connected to at least one circular arc. When a tangent segment is connected to the first routing port, the tangent segment is only connected to one circular arc. When a tangent segment is connected to the second routing port, the tangent segment is also only connected to one circular arc. Each of tangent segments other than the above two tangent segments, i.e., the two connected to the first routing port or the second routing port, is connected to a preceding circular arc and a following circular arc.

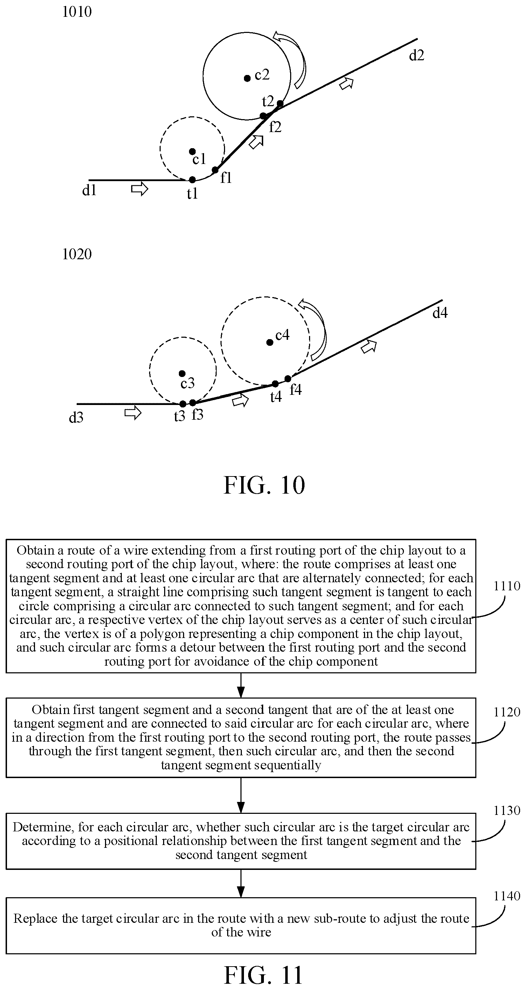

In all embodiments of the present disclosure, a degree of a central angle of each circular arc and a length of each tangent segment may not be limited, the circular arc is separately tangent to its preceding tangent segment and its following tangent segment. That is, the circular arcs and the tangent segments are alternately connected in the route. all embodiments of the present disclosure, the tangent segments and the circular arcs may be alternately connected in the route. In all embodiments of the present disclosure, a start of the routing may be the tangent segment connected to the first routing port, and an end of the routing may be the tangent segment connected to the second routing port. In some embodiments, as shown in 1020 in FIG. 10, line segment "d3t3", circular arc "t3 counterclockwise to f3", line segment "f3t4", circular arc "t4 counterclockwise to f4", and line segment "f4d4" are connected in sequence to obtain a route from the first routing port d3 to the second routing port d4, and line segment "d3t3", line segment "f3t4", and line segment "f4d4"are all tangent segments. That is, the tangent segments and the circular arcs are connected alternately. Line segment "d3t3" is tangent to a circle in which the circular arc "t3 counterclockwise to f3" is located and c3 is used as a center, line segment "f3t4" is tangent to both the circle in which the circular arc "t3 counterclockwise to f3" is located and c3 is used as the center and a circle in which the circular arc "t4 counterclockwise to f4" is located and c4 is used as a center, and line segment "f4d4" is tangent to the circle in which the circular arc "t4 counterclockwise to f4" is located and c4 is used as the center. The route starts at tangent segment "d3t3" connected to the first routing port d3 and ends at tangent segment "f4d4" connected to the second routing port d4.

In all embodiments of the present disclosure, there may be two circular arcs that are tangent to each other and are directly connected. In this case, a position at which the two circular arcs are connected is a point of tangency to each of the two circular arcs. It is considered that there is a tangent segment at the position at which the two circular arcs are connected, and the tangent segment connects the two circular arcs, but a length of the tangent segment is limited (e.g., zero).

In step 720, a target circular arc is determined among the at least one circular arc. The target circular arc is a circular arc introducing a loop into the route, and the circular arc introducing the loop into the route refers to that a central angle of the circular arc is greater than a threshold.

In all embodiments of the present disclosure, looping recognition may be performed on the at least one circular arc in the route, such that the target circular arc(s) are recognized. The circular arc introducing the loop into the route is a circular arc having a central angle greater than the threshold in an embodiment of the present disclosure. In the route, each circular arc has the preceding tangent segment and the following tangent segment. When the central angle of the circular arc is too large, the preceding tangent segment would intersect with the following tangent segment, and hence looping is introduced into the route. In all embodiments of the present disclosure, the threshold may be equal to 180 degrees. When the central angle of the circular arc is greater than 180 degrees, it is considered that the circular arc would introduce the route looping. A specific value of the threshold is not limited in embodiments of the present disclosure.

In some embodiments, as shown in FIG. 8, 810 shows that there is a target circular arc. A central angle of a circular arc from point a1 counterclockwise to point b1 is less than the threshold, and the circular arc "a1 counterclockwise to b1" does not belong to the target circular arc. A central angle of a circular arc from point a2 counterclockwise to point b2 is greater than the threshold, and the circular arc "a2 counterclockwise to b2" belongs to the target circular arc. In some embodiments, as shown in FIG. 8, 820 shows that there is no target circular arc. A central angle of a circular arc from point a3 counterclockwise to point b3 is less than the threshold, and the circular arc "a3 counterclockwise to b3" does not belong to the target circular arc. A central angle of a circular arc from point a4 counterclockwise to point b4 is less than the threshold, and the circular arc "a4 counterclockwise to b4" does not belong to the target circular arc. That is, in FIG. 8, the target circular arc determined according to step 720 is only the circular arc "a2 counterclockwise to b2".

In all embodiments of the present disclosure, the looping recognition in step 720 may also be referred to as circling recognition, loop recognition, or looping circling recognition.

In step 730, the target circular arc is replaced in the route with a new sub-route to adjust the route of the wire.

In all embodiments of the present disclosure, after determining the target circular arc, the target circular arc may be removed, and the route may be re-determined. For example, the target circular arc, its preceding tangent segment, and its following segment are all removed. The remaining segments in the route are re-connected to meet the foregoing requirement (e.g., not blocked by chip components and having no looping), and hence the route is adjusted.

In the technical solutions provided in an embodiment of the present disclosure, recognition is performed on the circular arcs in the route, a circular arc with a central angle greater than the threshold are recognized, and the circular arc is deleted, so that the adjusted routing does not include the circular arc with the central angle greater than the threshold. That is, all the circular arcs introducing route looping are deleted, and the circular arcs not introducing the route looping are reserved. Tangent segment(s) connecting the reserved circular arcs may be regenerated to obtain new circular arc(s). It is further determined whether the new circular arc(s) introduce the route looping. The iterative regeneration and determination continue until all the circular arcs in the routing do not introduce the route looping, and a final version of the route is obtained. Therefore, the wires in the routing scheme are free of overlapping caused by looping, and the routing on the chip layout is more reasonable and accurate.

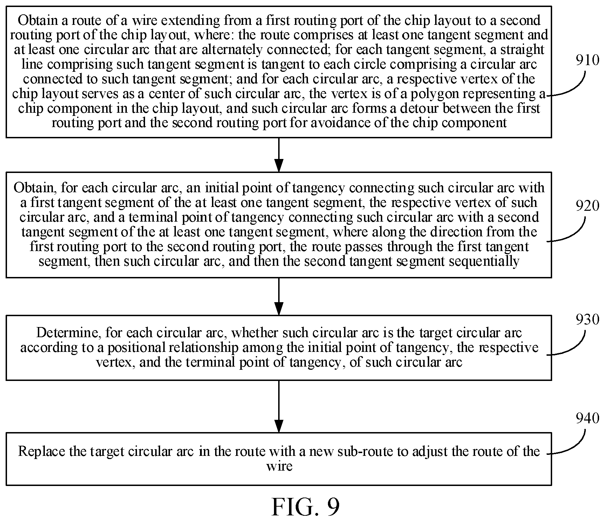

FIG. 9 is a flowchart of a method for routing on a chip layout according to another embodiment of the present disclosure. The method may be performed by a computer device. The computer device may be any electronic device having computing and storage capabilities, such as a PC, a tablet computer, or a server. For example, the computer device may run a computer program configured to perform the method, and the method for routing on a chip layout provided in an embodiment is implemented through the computer program. As shown in FIG. 9, the method may include at least one of the following steps 910 to 940.

In step 910, a route of a wire extending from a first routing port of the chip layout to a second routing port of the chip layout is obtained. The route comprises at least one tangent segment and at least one circular arc that are alternately connected. For each tangent segment, a straight line comprising such tangent segment is tangent to each circle comprising a circular arc, of the at least one circular arc, connected to such tangent segment. For each circular arc, a respective vertex of the chip layout serves as a center of such circular arc, the vertex is of a polygon representing a chip component in the chip layout, and such circular arc forms a detour between the first routing port and the second routing port for avoidance of the chip component.

In step 920, for each circular arc, an initial point of tangency connecting such circular arc with a first tangent segment of the at least one tangent segment, the respective vertex of such circular arc, and a terminal point of tangency connecting such circular arc with a second tangent segment of the at least one tangent segment, are obtained. Along the direction from the first routing port to the second routing port, the route passes through the first tangent segment, then such circular arc, and then the second tangent segment sequentially.

In all embodiments of the present disclosure, preceding and following tangent segments of each circular arc may be considered to include a preceding tangent segment (the first tangent segment) and a following tangent segment (the second tangent segment). A point of tangency between the first tangent segment and the circular arc is considered as an initial point of tangency of the circular arc, and a point of tangency between the second tangent segment and the circular arc is considered as a terminal point of tangency of the circular arc. Along direction from the first routing port to the second routing port, the route passes through the initial point of tangency, then the circular arc, and then the terminal point of tangency.

In some embodiments, as shown in 1010 in FIG. 10, in the direction from the first routing port to the second routing port, the route passes through the initial point t1 of tangency of the circular arc using c1 as a center, then the circular arc "t1 counterclockwise to f1" itself, and then the terminal point f1 of tangency of the circular arc. Then, the route passes through the line segment "f1t2", where t2 is the initial point of tangency of a next circular arc using c2 as a center. Afterwards, the route passes through such circular arc "t2 counterclockwise to f2", then passes through the terminal point f2 of tangency, and then extends further. Line segment "d1t1" is the first tangent segment of the circular arc using c1 as the center, and line segment "f1t2" is the second tangent segment of the circular arc using c1 as the center. Moreover, line segment "f1t2" is also the first tangent segment of the circular arc using c2 as the center, and line segment "f2d2" is a second tangent segment of the circular arc using c2 as the center.

In step 930, it is determined, for each circular arc, whether such circular arc is the target circular arc according to a positional relationship among the initial point of tangency, the respective vertex, and the terminal point of tangency, of such circular arc.

In all embodiments of the present disclosure, the route may extend counterclockwise along the circular arc. In such case, when an orientation of three ordered points, i.e., the initial point of tangency, the respective vertex, and the terminal point of tangency, (ordered in the above-listed sequence) of the circular arc is counterclockwise, it is determined that the circular arc is the target circular arc. When the orientation of three ordered points is clockwise, it is determined that the circular arc is not the target circular arc. In other embodiments, the route may extend clockwise along the circular arc. In such case, when the orientation of the three ordered points is clockwise, it is determined that the circular arc is the target circular arc. When the orientation of three ordered points is counterclockwise, it is determined that the circular arc is not the target circular arc.

In FIG. 10, the route extends counterclockwise in the circular arcs. In some embodiments, as shown in 1010 in FIG. 10, whether the circular arc using c1 as the center is the target circular arc is determined according to a positional relationship among the initial point t1 of tangency, the vertex c1, and the terminal point f1 of tangency. The orientation of the three points ordered as the initial point t1 of tangency, the vertex c1, and the terminal point f1 of tangency is clockwise, and hence such circular arc is not the target circular arc. In some embodiments, whether the circular arc using c2 as the center is the target circular arc is determined according to a positional relationship among the initial point t2 of tangency, the vertex c2, and the terminal point f2 of tangency. The orientation of the three points ordered as the initial point t2 of tangency, the vertex c2, and the terminal point f2 of tangency is counterclockwise, and hence such circular arc is the target circular arc.

In some embodiments, as shown in 1020 in FIG. 10, whether a circular arc using c3 as a center is the target circular arc is determined according to a positional relationship among the initial point t3 of tangency, the vertex c3, and the terminal point f3 of tangency. The orientation of the three points ordered as the initial point t3 of tangency, the vertex c3, and the terminal point f3 of tangency is clockwise, and hence such circular arc is not the target circular arc. In some embodiments, whether a circular arc using c4 as a center is the target circular arc is determined according to a positional relationship among the initial point t4 of tangency, the vertex c4, and the terminal point f4 of tangency. The orientation of the three points ordered as the initial point t4, the vertex c4, and the terminal point f4 of tangency is clockwise, the circular arc is not the target circular arc.

In all embodiments of the present disclosure, step 930 may include at least one of steps 931 to 933 (not shown in the figure).

In step 931, a first orientation and a second orientation are determined for each circular arc. The first orientation is an orientation among the initial point of tangency, the terminal point of tangency, and the respective vertex, of such circular arc, which are ordered in the above-listed sequence. The second orientation is an orientation pointing from the initial point of tangency along such circular arc to the terminal point of tangency. The first orientation and the second orientation each is either clockwise or counterclockwise.

The first orientation in step 931 is orientation of a rotation from the initial point of tangency to the terminal point of tangency and then to the vertex of the circular arc. It is appreciated the first orientation may be defined as the orientation of the rotation from the initial point of tangency to the terminal point of tangency and then to the vertex of the circular arc, may be alternatively defined as an orientation of a rotation from the terminal point of tangency to the initial point of tangency and then to the vertex of the circular arc, or may be alternatively defined as an orientation of a rotation from the vertex of the circular arc to the initial point of tangency and then to the terminal point of tangency. A specific form of the first orientation is not limited in the present disclosure. In addition to the first orientation, other directions may alternatively be used to determine whether the circular arc is the target circular arc. For example, in the foregoing embodiment in conjunction with FIG. 10, the orientation is defined for a rotation from the initial point of tangency to the vertex of the circular arc and then to the terminal point of tangency.

The second orientation shown in step 931 may be considered as an orientation of the circular arc in the route.

In step 932, it is determined, for each circular arc, that such circular arc is the target circular arc in response to the first orientation being different from the second orientation.

Step 933. it is determined, for each circular arc, that such circular arc is not the target circular arc in response to the first orientation being identical to the second orientation.

When the first orientation in step 931 is from the initial point of tangency to the terminal point of tangency and then to the vertex of the circular arc, it is determined that the circular arc is the target circular arc in a case that the first orientation is different from the second orientation, and it is determined that the circular arc is not the target circular arc in a case that the first orientation is identical to the second orientation.

Recognition is performed on the circular arcs in FIG. 10 by using the method in steps 931 to 933. As shown in FIG. 10, the second orientation, to be specific, the orientation of the circular arc in the route, is counterclockwise. In some embodiments, as shown in 1010 in FIG. 10, for the circular arc using c1 as the center, the first orientation, to be specific, the orientation of the rotation from the initial point t1 of tangency to the terminal point f1 of tangency and then to the vertex c1 of the circular arc, is counterclockwise, and the first orientation is the same as the second orientation, so that it is determined that the circular arc is not the target circular arc. For the circular arc using c2 as the center, the first orientation, to be specific, the orientation of the rotation from the initial point t2 of tangency to the terminal point f2 of tangency and then to the vertex c2 of the circular arc, is clockwise, and the first orientation is different from the second orientation, so that it is determined that the circular arc is the target circular arc. In some embodiments, as shown in 1020 in FIG. 10, for the circular arc using c3 as the center, the first orientation, to be specific, the orientation of the rotation direction from the initial point t3 of tangency to the terminal point f3 of tangency and then to the vertex c3 of the circular arc, is counterclockwise, and the first orientation is the same as the second orientation, so that it is determined that the circular arc is not the target circular arc. For the circular arc using c4 as the center, the first orientation, to be specific, t the orientation of the rotation from the initial point t4 of tangency to the terminal point f4 of tangency and then to the vertex c4 of the circular arc, is counterclockwise, and the first orientation is the same as the second orientation, so that it is determined that the circular arc is not the target circular arc.

Through the foregoing method, whether the circular arc is the target circular arc is determined depending on whether the first orientation is consistent with the second orientation, the solution is simple and convenient, and accuracy of the determined target circular arc is high.

In all embodiments of the present disclosure, step 930 may include at least one of steps 934 to 936 (not shown in the figure).

In step 934, a central angle of each circular arc is determined. A vertex of the central angle is the respective vertex of such circular arc, and two arms of the central angle pass through the initial point of tangency and the terminal point of tangency, respectively, of such circular arc.

A specific method for determining the central angle is not limited in the present disclosure. When positions of a center of a circle, an initial point of tangency, and a terminal point of tangency are known, a degree of the central angle can be calculated according to an arc length equation: l=πrα/180, where l is an arc length, r is a radius of the circular arc, and α is a degree of the central angle.

In step 935, it is determined, for each circular arc, that such circular arc is the target circular arc in response to the central angle of said circular arc being greater than the threshold.

In step 936, it is determined, for each circular arc, that such circular arc is not the target circular arc in response to the central angle of said circular arc being smaller than or equal to the threshold.

In all embodiments of the present disclosure, it may be determined that the circular arc is the target circular arc in a case that the central angle is greater than the threshold, and it may be determined that the circular arc is not the target circular arc in a case that the central angle is less than or equal to the threshold. In all embodiments of the present disclosure, the threshold may be 180 degrees.

In step 940, the target circular arc is replaced in the route with a new sub-route to adjust the route of the wire.

Through the foregoing method, whether the circular arc is the target circular arc is determined according to the degree of the central angle, a plurality of method for determining the target circular arc are provided, and diversity of manners of determining the target circular arc is improved.

In the technical solution provided in an embodiment of the present disclosure, whether the circular arc is the target circular arc is determined according to the positional relationship among the initial point of tangency, the vertex of the circular arc, and the terminal point of tangency, so that the accuracy of the determined target circular arc can be high. In addition, two manners are specifically shown. One manner is determining whether the circular arc is the target circular arc depending on whether the first orientation is consistent with the second orientation, and the other manner is determining whether the circular arc is the target circular arc according to the degree of the central angle. Therefore, the diversity of the manners of determining the target circular arc is improved.

FIG. 11 is a flowchart of a method for routing on a chip layout according to another embodiment of the present disclosure. The method may be performed by a computer device. The computer device may be any electronic device having computing and storage capabilities, such as a PC, a tablet computer, or a server. For example, the computer device may run a computer program configured to perform the method, and the method for routing on a chip layout provided in an embodiment is implemented through the computer program. As shown in FIG. 11, the method may include at least one of the following steps 1110 to 1140.

In step 1110, a route of a wire extending from a first routing port of the chip layout to a second routing port of the chip layout is obtained. The route comprises at least one tangent segment and at least one circular arc that are alternately connected. For each tangent segment, a straight line comprising such tangent segment is tangent to each circle comprising a circular arc, of the at least one circular arc, connected to such tangent segment. For each circular arc, a respective vertex of the chip layout serves as a center of such circular arc, the vertex is of a polygon representing a chip component in the chip layout, and such circular arc forms a detour between the first routing port and the second routing port for avoidance of the chip component.

In step 1120. a first tangent segment and a second tangent that are of the at least one tangent segment and are connected to said circular arc are obtained for each circular arc. In a direction from the first routing port to the second routing port, the route passes through the first tangent segment, then such circular arc, and then the second tangent segment sequentially.

In some embodiments, as shown in FIG. 10, line segment "d1t1" is the first tangent segment of a circular arc using c1 as a center, and line segment "f1t2" is the second tangent segment of the circular arc using c2 as the center. Moreover, line segment "f1t2" is also the first tangent segment of a circular arc using c2 as a center, and line segment "f2d2" is a second tangent segment of the circular arc using c2 as the center.

In step 1130, it is determined, for each circular arc, whether such circular arc is the target circular arc according to a positional relationship between the first tangent segment and the second tangent segment.

In all embodiments of the present disclosure, the positional relationship between the first tangent segment and the second tangent segment may include intersecting and not intersecting. In all embodiments of the present disclosure, it may be determined that the circular arc connected to the first tangent segment and the second tangent segment introduces a loop in a case that the first tangent segment intersects with the second tangent segment. In this case, the circular arc is determined to be the target circular arc.

In all embodiments of the present disclosure, it may be determined that the circular arc is the target circular arc in a case that the first tangent segment intersects with the second tangent segment, and it may be determined that the circular arc is not the target circular arc in a case that the first tangent segment does not intersect with the second tangent segment.

In some embodiments, as shown in 1010 in FIG. 10, the first tangent segment of the circular arc using c1 as the center does not intersect with the second tangent segment, and it is determined that the circular arc is not the target circular arc. The first tangent segment of the circular arc using c2 as the center intersects with the second tangent segment, it is determined that the circular arc is the target circular arc.

In some embodiments, as shown in 1020 in FIG. 10, the first tangent segment of the circular arc using c3 as the center does not intersect with the second tangent segment, and it is determined that the circular arc is not the target circular arc. The first tangent segment of the circular arc using c4 as the center does not intersect with the second tangent segment, it is determined that the circular arc is not the target circular arc.

In all embodiments of the present disclosure, it may be alternatively determined whether the circular arc is the target circular arc according to a position of an intersection point between the first tangent segment and the second tangent segment. For example, it may be determined that the circular arc does not introduce the loop in a case that: there is no intersection point between the first tangent segment and the second tangent segment, the intersection point between the first tangent segment and the second tangent segment is located on an extension line of the first tangent segment, or the intersection point between the first tangent segment and the second tangent segment is located on an extension line of the second tangent segment. In such case, the circular arc is not the target circular arc and does not need to be removed. In a case that the intersection point between the first tangent segment and the second tangent segment is located on the first tangent segment and on the second tangent segment, it may be determined that the circular arc introduces the loop and needs to be removed. In such case, it is determined that the circular arc is the target circular arc.

In step 1140, the target circular arc is replaced in the route with a new sub-route to adjust the route of the wire.

Other operations in this embodiment may refer to description of the foregoing embodiments and are not repeated herein.

In the technical solution provided in an embodiment of the present disclosure, whether the circular arc introduces the loop and needs to be removed is determined according to whether a preceding tangent segment and a following tangent segment of the circular arc intersect with each other. In a case that the two tangent segments intersect with each other, it is determined that the circular arc introduces the loop, and the circular arc needs to be removed. If the two tangent segments do not intersect with each other, it is determined that the circular arc does not introduce the loop, and the circular arc does not need to be removed. Therefore, in the present disclosure, efficiency of recognition of the circular arc is improved by determining whether the tangent segments intersect with each other, and a routing speed is further improved.

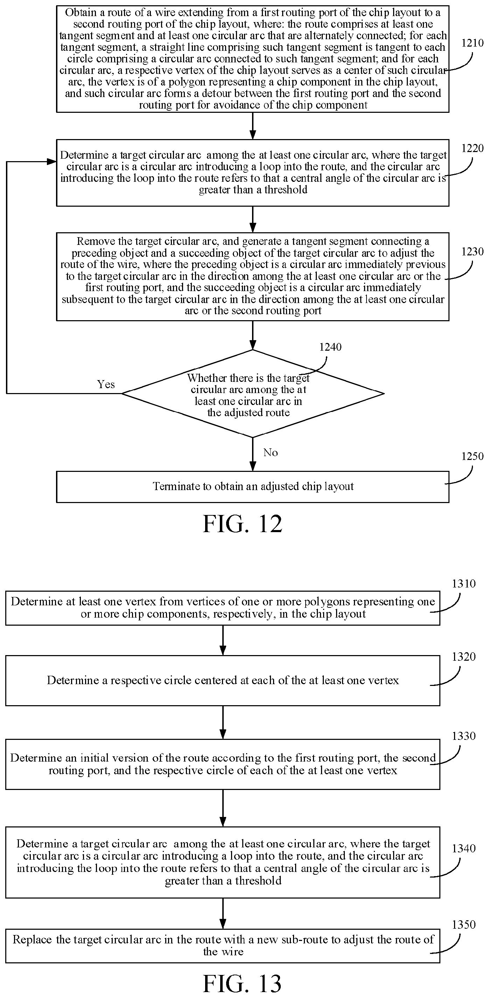

FIG. 12 is a flowchart of a method for routing on a chip layout according to another embodiment of the present disclosure. The method may be performed by a computer device. The computer device may be any electronic device having computing and storage capabilities, such as a PC, a tablet computer, or a server. For example, the computer device may run a computer program configured to perform the method, and the method for routing on a chip layout provided in an embodiment is implemented through the computer program. As shown in FIG. 12, the method may include at least one of the following steps 1210 to 1250.

In step 1210, a route of a wire extending from a first routing port of the chip layout to a second routing port of the chip layout is obtained. The route comprises at least one tangent segment and at least one circular arc that are alternately connected. For each tangent segment, a straight line comprising such tangent segment is tangent to each circle comprising a circular arc, of the at least one circular arc, connected to such tangent segment. For each circular arc, a respective vertex of the chip layout serves as a center of such circular arc, the vertex is of a polygon representing a chip component in the chip layout, and such circular arc forms a detour between the first routing port and the second routing port for avoidance of the chip component.

In step 1220, a target circular arc is determined among the at least one circular arc. The target circular arc is a circular arc introducing a loop into the route, and the circular arc introducing the loop into the route refers to that a central angle of the circular arc is greater than a threshold.

In step 1230, the target circular arc is removed, and a tangent segment connecting a preceding object and a succeeding object of the target circular arc is generated to adjust the route of the wire. The preceding object is a circular arc immediately previous to the target circular arc in the direction among the at least one circular arc, or the preceding object is the first routing port. The succeeding object is a circular arc immediately subsequent to the target circular arc in the direction among the at least one circular arc, or the succeeding object is the second routing port.

In all embodiments of the present disclosure, when the target circular arc is removed, tangent segments connected to the target circular arc may also be removed. For example, as shown in 1010 in FIG. 10, the first tangent segment intersects with the second tangent segment for the circular arc using c2 as a center, and it is determined that the circular arc is the target circular arc. In such case, the tangent segments "f1t2" and "f2d2" are removed along with the target circular arc using c2 as the center.

In all embodiments of the present disclosure, routing may be re-performed after the target circular arc is removed. In other words, the tangent segment(s) connecting the preceding connecting object and the succeeding connecting object of the target circular arc needs to be generated to obtain the adjusted route. In all embodiments of the present disclosure, the preceding connecting object of the target circular arc may be the first routing port, while the succeeding connecting object is the subsequent circular arc. In such case, a tangent segment, connecting the first routing port, of the subsequent circular arc needs to be generated. When such change in the connection occurs, a central angle of the subsequent circular arc may also change. In all embodiments of the present disclosure, the preceding connecting object of the target circular arc may be the previous circular arc, while the succeeding connecting object is the subsequent circular arc. In such case, a common tangent between the previous circular arc to the subsequent circular arc may be generated. When such change in the connection occurs, central angles of the previous circular arc and the subsequent circular arc may also change. In all embodiments of the present disclosure, the preceding connecting object of the target circular arc may be the previous circular arc, while the succeeding connecting object is the second routing port. In such case, a tangent segment, connecting the second routing port, of the previous circular arc needs to be generated. When such change in the connection occurs, a central angle of the previous circular arc may also change.

In all embodiments of the present disclosure, after the target circular arc is removed, as an alternative, a new circular arc connecting the tangent segments that are once connected to the target circular arc may be generated. As shown in 1010 in FIG. 10, the first tangent segment intersects with the second tangent segment for the circular arc using c2 as the center, and it is determined that the circular arc is the target circular arc. After the target circular arc using c2 as the center is removed, a new circular arc connecting the tangent segment "f1t2" and the tangent segment "f2d2" is generated. The newly generated circular arc has a possibility of being identical to the target circular arc using c2 as the center, and thus may introduce a repeated iteration of removal and generation. Such manner would not be described in detail herein.

In step 1240, it is determined whether there is the target circular arc among the at least one circular arc in the adjusted route.

In s all embodiments of the present disclosure, all circular arcs may be checked one by one to determine whether there is the target circular arc in the adjusted route. As an alternative, not all circular arcs but only the previous and subsequent circular arcs of the deleted circular arc are checked to determine whether there is the target circular arc in the adjusted route. A reason lies in that points of tangency of the previous and subsequent circular arcs may be changed during the adjustment, and hence a loop may be introduced by the altered previous and subsequent circular arcs. In comparison, circular arcs other than the previous and subsequent circular arcs of the target circular arc are little affected. Hence, not all circular arcs but only the previous and subsequent circular arcs of the deleted circular arc are checked after the adjustment, improving recognition efficiency.

The process returns step 1220, in a case that there is the target circular arc. The process proceeds to step 1250 is performed, in a case that there is no target circular arc.

In step 1250, the process terminates to obtain an adjusted chip layout.

In all embodiments of the present disclosure, when no circular arc needs to be further removed after traversing the circular arcs in the adjusted route, it may be determined that there is no route looping in the in the adjusted route and the current version of the route is a final version of the route. That is, when routing of the corresponding physical device follows the current route on the chip layout, wires in the physical device would not suffer the looping. Herein the routing in embodiments generally refers to routing for a chip layout and does not refer to deploying actual wires, unless explicitly expressed otherwise. That is, actual connection for devices is reflected in a virtual (e.g., digitalized) form.

In all embodiments of the present disclosure, all the circular arcs may be traversed only once. When it is determined that a circular arc is not the target circular arc, the recognition is performed on a next circular arc. When it is determined that a circular arc is the target circular arc, the circular arc is removed, preceding and succeeding connecting objects are re-connected, and it is determined whether none of the preceding and succeeding connecting objects after the reconnection needs to be removed. When none of the preceding and succeeding connecting objects after the reconnection needs to be removed, the recognition is performed on a next circular arc.

In the technical solution provided in an embodiment of the present disclosure, after the target circular arc introducing the loop is removed, the tangent segment connecting the preceding connecting object and the succeeding connecting object of the target circular arc is generated, to maintain completeness of the route. Re-generating the tangent segment connecting the preceding connecting object and the succeeding connecting object of the target circular arc, instead of only generating the new circular arc connected to the tangent segments once connecting the target circular arc, can reduce the possibility that the route loop also occurs in the adjusted route and the possibility of errors in the process.

In addition, the recognition is re-performed on the adjusted route, ensuring that there is no circular arc introducing the loop into the adjusted routing. Therefore, overlapping of the wires due to the looping is avoided in the routing, so that the routing on the chip layout is more reasonable and accurate.

FIG. 13 is a flowchart of a method for routing on a chip layout according to another embodiment of the present disclosure. The method may be performed by a computer device. The computer device may be any electronic device having computing and storage capabilities, such as a PC, a tablet computer, or a server. For example, the computer device may run a computer program configured to perform the method, and the method for routing on a chip layout provided in an embodiment is implemented through the computer program. As shown in FIG. 13, the method may include at least one of the following operations 1310 to 1350.

In step 1310, at least one vertex is determined from vertices of one or more polygons representing one or more chip components, respectively, in the chip layout.

In all embodiments of the present disclosure, a line segment connecting the first routing port and the second routing port may be determined to serve as an initial line segment, where the first routing port serves as a starting point of the initial line segment, and the second routing port serves an end point of the initial line segment. Then, iterations are performed, each of which comprises, for each initial line segment: determining a vertex for said initial line segment according to distances from the vertices of the one or more polygons to said initial line segment, determining the vertex for said initial line segment as an intermediate point, determining a first line segment connecting the intermediate point and the start point of said initial line segment, determining a second line segment connecting the intermediate point and the end point of said initial line segment, and determining each of the first line segment and the second line segment as new initial line segments that replace said initial segment. The iterations are repeated until all initial line segments need to detour for avoidance of none of the vertices of the one or more polygons. Each initial line segment connects any two points among: the first routing port, the at least one determined vertex, and the second routing port.

In s all embodiments of the present disclosure, positions of the chip components in the chip layout may be fixed. In other words, positions of the points corresponding to the components are fixed. In all embodiments of the present disclosure, for a connection line between the first routing port and the second routing port, a vertex having a shortest distance to the connection line may be determined to serve a vertex to be avoided first using a detour formed by line segments. Using the vertex, the connection line between the first routing port and the second routing port is replaced by two line segments. Again, it is determined whether there is a vertex that needs to be avoided using a detour for the two line segments. The process is repeated until there is no vertex that needs to be avoided using a detour for all line segment obtained through a binary-tree structure. That is, the repetitive determination is terminated in such case. In all embodiments of the present disclosure, the distance from the determined vertex to the line segment may further need to satisfy at least a distance condition besides the minimum requirement. For example, the distance from such vertex to the line segment further needs to be less than a first value. That is, only when the distance from such vertex to the line segment is shortest and less than the first value, such vertex is determined to be the vertex that needs to be avoided using a detour for a corresponding line segment.

In step 1320. a respective circle centered at each of the at least one vertex is determined.

In all embodiments of the present disclosure, during the routing, each vertex may be "circled". A radius of the circle of each vertex is not limited in the present disclosure. The radius may be preset or may be generated according to an algorithm.

In all embodiments of the present disclosure, a radius of the respective circle of each vertex may be determined according to a quantity of wires that have a detour for avoidance of such vertex. For example, the radius is equal to a shortest distance for safe routing in response to the quantity being equal to zero, and the radius is equal to a sum of the shortest distance for safe routing and a product of a positive integer s and a space between adjacent routes, in response to the quantity being equal to s. The shortest distance and the space may be constants. The respective circle of each vertex is determined according to the respective radius.

In all embodiments of the present disclosure, the wire having a detour for avoidance of a vertex may be considered as a geometric sub-route (a part of a route) that has been determined to avoid such vertex using a detour. For point a, all geometric sub-routes that have been determined to avoid point a using a detour would extend around a. As their quantity increases, a radius of a new circular arc making a detour around the point a shall be greater.

In all embodiments of the present disclosure, in a case that the quantity of the wires is 0, the radius of the circle corresponding to the k^{th} vertex may be equal to the shortest distance for safe routing. In a case that the quantity is s, the radius r of the circle for the (s+1)^{th} wire at such vertex may be equal to a sum of s*(space between adjacent routes) and the shortest distance for safe routing. Specific values of the shortest distance and the space are not limited in the present disclosure.

In step 1330, an initial version of the route is determined according to the first routing port, the second routing port, and the respective circle of each of the at least one vertex.

A specific manner of determining the initial version of the route according to the first routing port, the second routing port, and t the respective circle of each vertex is not limited in embodiments of the present disclosure, as long as determined route satisfies a constraint condition. In all embodiments of the present disclosure, the constraint condition may refer to that the route includes at least two tangent segments and at least one circular arc. Each circular arc has a tangent line including its preceding tangent segment and a tangent line including its following tangent segment. In all embodiments of the present disclosure, the route may include only the tangent segment(s) and the circular arc(s).

In all embodiments of the present disclosure, the at least one vertex may be ordered in a sequence along the route in the direction from the first routing port to the second routing port. A tangent, passing through the first routing port, of the respective circle of a head vertex of the at least one vertex in the sequence is determined, and a point of the tangent passing through the first routing port contacting the respective circle of the head vertex is determined to serve as an initial point of tangency of the head vertex. For each pair of adjacent vertices of the at least one vertex in the sequence, a common tangent between the respective circle of a vertex former in the sequence in said pair and the respective circle of a vertex latter in the sequence in said pair is determined, a point of the common tangent contacting the respective circle of the former vertex is determined to serve as a terminal point of tangency of the former vertex, and a point of the common tangent contacting the respective circle of the latter vertex is determined to serve as an initial point of tangency of the latter vertex. A tangent, passing through the second routing port, of the respective circle of a tail vertex of the at least one vertex in the sequence is determined, and a point of the tangent passing through the second routing port contacting the respective circle of the tail vertex is determined to serve as a terminal point of tangency of the tail vertex. For each vertex, a circular arc on the respective circle of such vertex from the initial point of tangency to the terminal point of tangency of such vertex is determined to serve as a respective circular arc of such vertex. The at least one tangent segment and the at least one respective circular arc of the at least one vertex are sequentially connected from the first routing port to the second routing port to obtain the initial version of the route.

In all embodiments of the present disclosure, when the common tangent between the circle of the former vertex and the circle of the latter vertex is determined, the tangent segment formed between the two points of tangency may not intersect with a line segment connecting the former vertex and the latter vertex.

In step 1340, a target circular arc is determined among the at least one circular arc. The target circular arc is a circular arc introducing a loop into the route, and the circular arc introducing the loop into the route refers to that a central angle of the circular arc is greater than a threshold.

In step 1350, the target circular arc is replaced in the route with a new sub-route to adjust the route of the wire.

In the technical solution provided in an embodiment of the present disclosure, when the route is determined, a proper vertex is selected as a vertex from vertexes of a component in a distance-first manner, and proper vertexes are determined through a binary-tree-like structure for multiple times. A manner of determining vertexes through binary-tree-like structure can effectively improve accuracy of determined vertexes and can greatly improve efficiency of determining vertexes.

Moreover, the route determined by connecting the circular arc(s) and the tangent segment(s) in sequence is a shortest route, which is conducive to reducing routing costs. In addition, the radius of the circular arc is determined according to the quantity of lines that are arranged, which is conducive to avoiding intersection between lines, thereby improving accuracy of the routing.

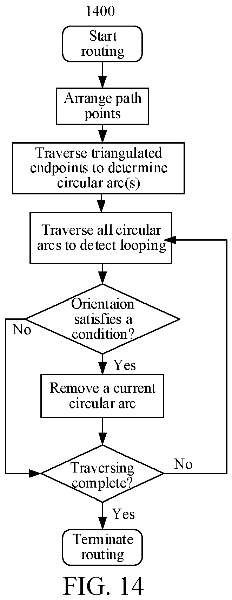

FIG. 14 is a block diagram of a method for routing on a chip layout according to an embodiment of the present disclosure. The method may be performed by a computer device. The computer device may be any electronic device having computing and storage capabilities, such as a PC, a tablet computer, or a server. For example, the computer device may run a computer program configured to perform the method, and the method for routing on a chip layout provided in an embodiment is implemented through the computer program.

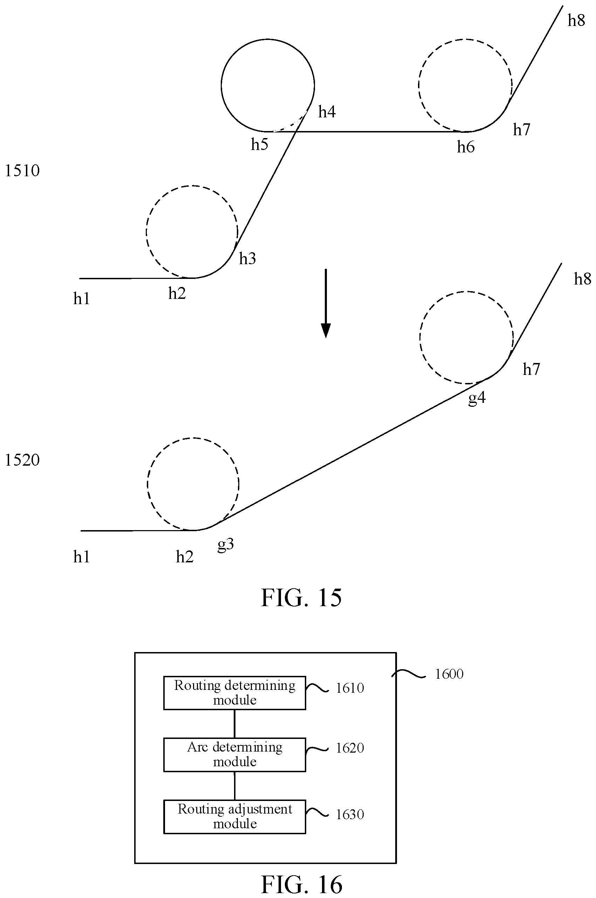

As shown in 1400 in FIG. 14, an algorithm for automatically recognizing and properly avoiding looping of signal lines (wires) is designed in an embodiment of the present disclosure, a problem of the looping of signal lines during routing is successively resolved, so that the routing of the signal lines is more proper and highly efficient. An initial path point is first arranged, and a circular arc is determined by traversing routingedge endpoints. Routingedge refers to a triangulated line (i.e., a line obtained through Delaunay Triangulation) on which the initial path point is located, and the routingedge endpoint is a triangulation point (i.e., a point obtained through Delaunay Triangulation). In all embodiments of the present disclosure, the triangulation point may be a vertex of a chip component. There are multiple path points in a round of traverse, so that there are multiple endpoints of triangulated lines. A point that needs to be avoided using a detour needs to be selected through sorting from the endpoints as a center of a circle, and a radius needs to be determined. A process of traverse may refer to the foregoing embodiments, and recursive traverse is performed. At the beginning, only two points, i.e., an initial point and a terminal point, and one line segment are determined, and the line segment is divided into two line segments in each subsequent round, and proper point(s) are selected in each round, until no proper point can be found and the recursion stops. After all endpoints that need to be avoided using a detour are determined, all circular arcs and radiuses are determined according to a radius of a circle corresponding to each endpoint. Then, all the circular arcs are traversed for looping recognition. It is whether the first orientation is the same as the second orientation. If the first orientation is the same as the second orientation, it is considered that a circular arc is not the target circular arc; and if the first orientation is different from the second orientation, it is considered that the circular arc is the target circular arc, and the circular arc is removed. It is determined whether the traverse is completed. In a case that the traverse through all the circular arcs is completed, the routing process terminates. That is, a main concept is traversing each circular arc on a path line and detecting whether such circular arc introduces the loop. If the circular arc introduces the loop, the circular arc is deleted, and positions of points of tangency of preceding and subsequent circular arcs of the deleted circular arc are re-calculated for new connection. Specifically, FIG. 15 is used as an example. In an example 1510 in FIG. 15, assuming that a route direction is from a first routing port h1 to a second routing port h8, the route includes a tangent segment "h1h2", a circular arc "h2 counterclockwise to h3", a tangent segment "h3h4", a circular arc "h4 counterclockwise to h5", a tangent segment "h5h6", a circular arc "h6 counterclockwise to h7", and a tangent segment "h7h8". According to technical solutions provided in the foregoing embodiments, the circular arc "h4 counterclockwise to h5" introduces the loop. Based on the technical solution provided in embodiments of the present disclosure, the circular arc "h4 counterclockwise to h5" is considered as the target circular arc, namely, the circular arc that needs to be deleted. Along with the circular arc, the tangent segment "h3h4" and the tangent segment "h5h6" are also deleted. As shown in 1520 in FIG. 15, a common tangent, namely, a tangent segment "g3g4" between a circle on which the circular arc "h2 counterclockwise to h3" is located and a circle on which the circular arc "h6 counterclockwise to h7" is located is generated. According to the tangent segment "g3g4", a new circular arc "h2 counterclockwise to g3" and a new circular arc "g4 counterclockwise to h7" that are connected to the new tangent segment can be obtained. This process may be analogized to an operation of deleting a node in a singly linked list and connecting a preceding node to a following node of the deleted node. The routing determined based on the technical solutions in embodiments of the present disclosure resolves a problem of th looping of the signal lines completely, and a signal line would not be too close to or even overlap with an adjacent signal line.

A core link of an improved algorithm provided in the present disclosure is automatic recognizing and avoiding the looping of the signal lines. When corresponding analysis and recognition are performed on a circular arc, if arcwind is not the same as fcwind (arcwind being an orientation of a path in a circular arc, namely, the second orientation, and tfcwind being an orientation from an initial point of tangency of a circular arc to an terminal point of tangency and then to a center of a circular arc, namely, the first orientation), the circular arc introduces the loop and shall be adjusted subsequently. If arcwind is the same as tfcwind, there is no looping introduced. Proper avoiding of routing looping of signal lines is implemented by deleting looping-introduced circular arcs and connecting preceding and subsequent circular arcs by re-calculation on points of tangency. In all embodiments of the present disclosure, because a position of a point of tangency of a circular arc dynamically changes, the following two cases may occur during arrangement. In a first case, a circular arc is normal and does not introduce the loop at the beginning. Since a position of its point of tangency changes, the circular arc introduces the loop afterwards. In a second case, a circular arc introduces the loop at the beginning. Since an adjacent circular arc changes and a position of its point of tangency correspondingly changes, the circular arc is restored to a normal state afterwards. In the foregoing schemes, recognition and determining logic for the looping circular arcs in the algorithm is carried out after positions of points of tangency of circular arcs are completely determined (through recursive traversing on the initial path point, where the most proper triangulated points are determined to serve as the intermediate points recursively using the binary-tree structure, and all centers and radiuses of circles used for avoidance (making a detour) are determined, and thus corresponding tangent points are determined) to perform corresponding determination and adjustment. In addition, after the looping-introduced circular arcs are deleted, positions of points of tangency of the preceding and subsequent circular arcs of the deleted circular arcs (if existing) need to be re-calculated, so that the transition of the signal lines between the circular arcs are kept smooth and reasonable.

In an exemplary embodiment, a chip is further provided. The chip is manufactured on a basis of a chip layout with routing obtained through the method for routing on the chip layout according to any foregoing embodiment. In all embodiments of the present disclosure, the chip may be a quantum chip.

The following is an apparatus embodiment of the present disclosure and may be used for performing method embodiments of the present disclosure. For details not disclosed in the apparatus embodiment of the present disclosure, refer to the method embodiments of the present disclosure.

FIG. 16 is a block diagram of an apparatus for routing on a chip layout according to an embodiment of the present disclosure. The apparatus has a function of implementing the foregoing method examples, and the function may be implemented through hardware, or may be implemented in such a manner that the hardware executes related software. The apparatus may be the computer device described above or may be disposed in the computer device. As shown in FIG. 16, an apparatus 1600 includes: a routing determining module 1610, an arc determining module 1620, and a routing adjustment module 1630.

The routing determining module 1610 is configured to determine a route of a wire extending from a first routing port of the chip layout to a second routing port of the chip layout. The route comprises at least one tangent segment and at least one circular arc that are alternately connected. For each of the at least one tangent segment, a straight line comprising such tangent segment is tangent to each circle comprising a circular arc that is of the at least one circular arc and is connected to such tangent segment. For each circular arc of the at least one circuit arcs, a respective vertex of the chip layout serves as a center of such circular arc, the vertex is of a polygon representing a chip component in the chip layout, and such circular arc forms a detour between the first routing port and the second routing port for avoidance of the chip component.

The arc determining module 1620 is configured to perform recognition on the circular arcs included in the routing, to determine a target circular arc. The target circular arc is a circular arc in route looping. The route looping means that a central angle of the circular arc is greater than a threshold.

The routing adjustment module 1630 is configured to replace, in the route, the target circular arc with a new sub-route to adjust the route of the wire.

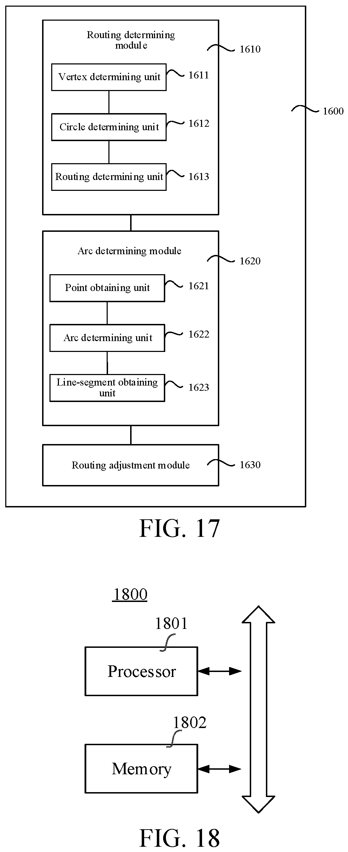

In all embodiments of the present disclosure, as shown in FIG. 17, the arc determining module 1620 may include a point obtaining unit 1621 and an arc determining unit 1622.

The point obtaining unit 1621 is configured to obtain, for each of the at least one circular arc, an initial point of tangency connecting such circular arc with a first tangent segment of a first tangent segment of, the respective vertex of such circular arc, and a terminal point of tangency connecting such circular arc with a second tangent segment of a first tangent segment of. In a direction from the first routing port to the second routing port, the route passes through the first tangent segment, such circular arc, and the second tangent segment in the above-listed sequence.

The arc determining unit 1622 is configured to determine, for each of the at least one circular arc, whether such circular arc is the target circular arc according to a positional relationship among the initial point of tangency, the respective vertex of such circular arc, and the terminal point of tangency.

In all embodiments of the present disclosure, the circular arc determining unit 1622 may be configured to, for each of the at least one circular arc: determine a first orientation and a second orientation, where the first orientation is an orientation among the initial point of tangency, the terminal point of tangency, and the respective vertex of such circular arc, which are ordered in the above-listed sequence, the second orientation is an orientation pointing from the initial point of tangency along such circular arc to the terminal point of tangency, and the first orientation and the second orientation each is either clockwise or counterclockwise; determine that said circular arc is the target circular arc in response to the first orientation being different from the second orientation; and determine that said circular arc is not the target circular arc in response to the first orientation being identical to the second orientation.

In all embodiments of the present disclosure, the circular arc determining unit 1622 may be further configured to, for each of the at least one circular arc: determine a central angle of such circular arc, wherein a vertex of the central angle is the respective vertex of such circular arc, and two arms of the central angle passes through the initial point of tangency and the terminal point of tangency, respectively; determine that said circular arc is the target circular arc in response to the central angle of said circular arc being greater than the threshold; and determine that said circular arc is not the target circular arc in response to the central angle of said circular arc being smaller than or equal to the threshold.

In all embodiments of the present disclosure, as shown in FIG. 17, the arc determining module 1620 may further include a line-segment obtaining unit 1623.

The line-segment obtaining unit 1623 is configured to determine, for each of the at least one circular arc, a first tangent segment and a second tangent that are of the at least one tangent segment and are connected to such circular arc. In a direction from the first routing port to the second routing port, the route passes through the first tangent segment, such circular arc, and the second tangent segment in the above-listed sequence.

The arc determining unit 1622 is configured to determine, for each of the at least one circular arc, whether such circular arc is the target circular arc according to a positional relationship between the first tangent segment and the second tangent segment.

In all embodiments of the present disclosure, the arc determining unit 1622 may be further configured to, for each of the at least one circular arc: determine that such circular arc is the target circular arc in response to the first tangent segment intersecting with the second tangent segment; and determine that such circular arc is not the target circular arc in response to the first tangent segment not intersecting with the second tangent segment.

In all embodiments of the present disclosure, the routing adjustment module 1630 may be configured to: remove the target circular arc, and re-generate a tangent segment connecting a preceding object and a succeeding object of the target circular arc, to adjust the route of the wire. The preceding object is a circular arc immediately previous to the target circular arc in the direction among the at least one circular arc or is the first routing port. The succeeding object is a circular arc immediately subsequent to the target circular arc in the direction among the at least one circular arc or is the second routing port.

In all embodiments of the present disclosure, the arc determining module 1620 may be further configured to determine whether there is the target circular arc among the at least one circular arc, and terminate a process of routing to obtain an adjusted chip layout in response to determining that there is no target circular arc among the at least one circular arc.

In all embodiments of the present disclosure, as shown in FIG. 17, the routing determining module 1610 may include a vertex determining unit 1611, a circle determining unit 1612, and a routing determining unit 1613.

The vertex determining unit 1611 is configured to determine at least one vertex from vertices of one or more polygons representing one or more chip components, respectively, in the chip layout.

The circle determining unit 1612 is configured to determine, for each of the at least one vertex, a respective circle centered at such vertex.

The routing determining unit 1613 is configured to determine an initial version of the route according to the first routing port, the second routing port, and the respective circle of each of the at least one vertex.

In all embodiments of the present disclosure, the at least one vertex may be ordered in a sequence along the route in the direction from the first routing port to the second routing port. The routing determining unit 1613 is configured to: determine a tangent, passing through the first routing port, of the respective circle of a head vertex of the at least one vertex in the sequence, and determine a point of the tangent passing through the first routing port contacting the respective circle of the head vertex as an initial point of tangency of the head vertex; for each pair of adjacent vertices of the at least one vertex, determine a common tangent between the respective circle of a vertex former in the sequence in such pair and the respective circle of a vertex latter in the sequence in such pair, determine a point of the common tangent contacting the respective circle of the former vertex as a terminal point of tangency of the former vertex, and determine a point of the common tangent contacting the respective circle of the latter vertex as an initial point of tangency of the latter vertex; determine a tangent, passing through the second routing port, of the respective circle of a tail vertex of the at least one vertex in the sequence, and determine a point of the tangent passing through the second routing port contacting the respective circle of the tail vertex as a terminal point of tangency of the tail vertex; for each vertex of the at least one vertex, determine a circular arc on the respective circle of such vertex from the initial point of tangency to the terminal point of tangency of such vertex as a respective circular arc of such vertex; and connect the at least one tangent segment and the at least one respective circular arc of the at least one vertex sequentially from the first routing port to the second routing port to obtain the initial version of the route.

In all embodiments of the present disclosure, the circle determining unit 1612 may be configured to, for each of the at least one vertex: determine a radius of the respective circle of such vertex according to a quantity of wires that have a detour for avoidance of such vertex, wherein the radius is equal to a shortest distance for safe routing in response to the quantity being equal to zero, the radius is equal to a sum of the shortest distance for safe routing and a product of a positive integer s and a space between adjacent routes in response to the quantity being equal to s, and the shortest distance and the space are constants; and determine the respective circle of such vertex according to the radius.

In s all embodiments of the present disclosure, the vertex determining unit 1611 may be configured to: determine a line segment connecting the first routing port and the second routing port to serve as an initial line segment, where the first routing port serves as a starting point of the initial line segment, and the second routing port serves an end point of the initial line segment; and repeat iterations each of which comprises: for each initial line segment, determining a vertex for such initial line segment according to distances from the vertices of the one or more polygons to such initial line segment, determining the vertex for the initial line segment as an intermediate point, determining a first line segment connecting the intermediate point and the initial point of the initial line segment, determining a second line segment connecting the intermediate point and the terminal point of the initial line segment, and determining each of the first line segment and the second line segment as new initial line segments that replaces such initial line segment. The iterations are repeated until all initial line segments needs to detour for avoidance of none of the vertices of the one or more polygons, where each initial line segment connects any two points among: the first routing port, the at least one determined vertex, and the second routing port.

When an apparatus provided in the foregoing embodiment implements functions, division of the foregoing functional modules is merely used as an example for description. In practice, the foregoing functions may be assigned to and completed by different functional modules as required. That is, a content structure of the device may be divided into different functional modules to complete all or some of the functions described above. In addition, the apparatus provided in the foregoing embodiment belongs to the same conception as the method embodiments. For a specific implementation process thereof, reference may be made to the method embodiments. Details are not described herein again.

FIG. 18 is a structural block diagram of a computer device 1800 according to an embodiment of the present disclosure. The computer device 1800 may be any electronic device having data computing, processing, and storage capabilities. The computer device 1800 may be configured to implement the routing method for routing on a chip layout provided in the foregoing embodiments.

Generally, the computer device 1800 includes: a processor 1801 and a memory 1802.

The processor 1801 may include one or more processing cores, such as a 4-core processor and an 8-core processor. The processor 1801 may be implemented in at least one hardware form of a digital signal processor (DSP), a field-programmable gate array (FPGA), and a programmable logic array (PLA). The processor 1801 may alternatively include a main processor and a coprocessor. The main processor is a processor configured to process data in an active state, also referred to as a central processing unit (CPU). The coprocessor is a low-power consumption processor configured to process data in a standby state. In all embodiments of the present disclosure, the processor 1801 may be integrated with a graphics processing unit (GPU). The GPU is configured to render and draw content that needs to be displayed on a display screen. In all embodiments of the present disclosure, the processor 1801 may further include an artificial intelligence (AI) processor. The AI processor is configured to process computing operations related to machine learning.

The memory 1802 may include one or more computer-readable storage media. The computer-readable storage medium may be non-transient. The memory 1802 may further include a high-speed random access memory and a nonvolatile memory, for example, one or more disk storage devices or flash storage devices. In all embodiments of the present disclosure, the non-transient computer-readable storage medium in the memory 1802 may be configured to store a computer program. The computer program is configured to be executed by one or more processors to implement the foregoing method for routing on a chip layout.

A person skilled in the art may understand that the structure shown in FIG. 18 does not constitute any limitation on the computer device 1800, and the computer device 1800 may include more or fewer components than those shown in the figure, or some components may be combined, or a different component deployment may be used.

In an exemplary embodiment, a computer-readable storage medium is further provided. The computer-readable storage medium has a computer program stored therein. The computer program is executed by a processor to implement the foregoing method for routing on a chip layout. In all embodiments of the present disclosure, the computer-readable storage medium may include: a read-only memory (ROM), a random-access memory (RAM), a solid state drive (SSD), an optical disc, and the like. The random-access memory may include a resistance random access memory (ReRAM) and a dynamic random-access memory (DRAM).

In an exemplary embodiment, a computer program product is further provided. The computer program product includes a computer program. The computer program is stored in a computer-readable storage medium. A processor of a computer device reads the computer program from the computer-readable storage medium. The processor executes the computer program, to cause the computer device to perform the foregoing method for routing on a chip layout.

"Plurality of" mentioned in the specification means two or more. "And/or" describes an association relationship between associated objects and indicates that there may be three relationships. For example, A and/or B may indicate three cases that only A exists, both A and B exist, and only B exists. The character "/" generally indicates an "or" relationship between the associated objects. In addition, the operation numbers described in this specification merely schematically show a possible performing sequence of the operations. In all embodiments of the present disclosure, the operations may not be performed according to the number sequence. For example, two operations with different numbers may be performed simultaneously, or two operations with different numbers may be performed according to a sequence contrary to the sequence shown in the figure. This is not limited in embodiments of the present disclosure.

The foregoing descriptions are merely exemplary embodiments of the present disclosure but are not intended to limit the present disclosure.

## Claims

1. A method for routing on a chip layout, applicable to a computer device, the method comprising:
obtaining a route of a wire extending from a first routing port of the chip layout to a second routing port of the chip layout, wherein:
the route comprises at least one tangent segment and at least one circular arc that are alternately connected;
for each of the at least one tangent segment, a straight line comprising said tangent segment is tangent to each circle comprising a circular arc, of the at least one circular arc, connected to said tangent segment; and
for each circular arc of the at least one circuit arc, a respective vertex of the chip layout serves as a center of said circular arc, the vertex is of a polygon representing a chip component in the chip layout, and said circular arc forms a detour between the first routing port and the second routing port for avoidance of the chip component;
determining a target circular arc among the at least one circular arc, wherein the target circular arc is a circular arc introducing a loop into the route, and the circular arc introducing the loop into the route refers to that a central angle of the circular arc is greater than a threshold; and
replacing, in the route, the target circular arc with a new sub-route to adjust the route of the wire.

2. The method according to claim 1, wherein determining the target circular arc among the at least one circular arc comprises, for each of the at least one circular arc:
obtaining an initial point of tangency connecting said circular arc with a first tangent segment of the at least one tangent segment, the respective vertex of said circular arc, and an terminal point of tangency connecting said circular arc with a second tangent segment of the at least one tangent segment, wherein in a direction from the first routing port to the second routing port, the route passes through the first tangent segment, said circular arc, and the second tangent segment in the above-listed sequence; and
determining whether said circular arc is the target circular arc according to a positional relationship among the initial point of tangency, the respective vertex of said circular arc, and the terminal point of tangency.

3. The method according to claim 2, wherein determining whether said circular arc is the target circular arc according to the positional relationship among the initial point of tangency, the respective vertex of said circular arc, and the terminal point of tangency comprises:
determining a first orientation and a second orientation, wherein the first orientation is an orientation among the initial point of tangency, and the terminal point of tangency, and the respective vertex of said circular arc, which are ordered in the above-listed sequence, the second orientation is an orientation pointing from the initial point of tangency along said circular arc to the terminal point of tangency, and the first orientation and the second orientation each is either clockwise or counterclockwise;
determining that said circular arc is the target circular arc in response to the first orientation being different from the second orientation; and
determining that said circular arc is not the target circular arc in response to the first orientation being identical to the second orientation.

4. The method according to claim 2, wherein determining whether said circular arc is the target circular arc according to the positional relationship among the initial point of tangency, the respective vertex of said circular arc, and the terminal point of tangency comprises:
determining a central angle of said circular arc, wherein a vertex of the central angle is the respective vertex of said circular arc, and two arms of the central angle passes through the initial point of tangency and the terminal point of tangency, respectively;
determining that said circular arc is the target circular arc in response to the central angle of said circular arc being greater than the threshold; and
determining that said circular arc is not the target circular arc in response to the central angle of said circular arc being smaller than or equal to the threshold.

5. The method according to claim 1, wherein determining the target circular arc among the at least one circular arc comprises, for each of the at least one circular arc:
determining a first tangent segment and a second tangent that are of the at least one tangent segment and are connected to said circular arc, wherein in a direction from the first routing port to the second routing port, the route passes through the first tangent segment, said circular arc, and the second tangent segment in the above-listed sequence; and
determining whether said circular arc is the target circular arc according to a positional relationship between the first tangent segment and the second tangent segment.

6. The method according to claim 5, wherein determining whether said circular arc is the target circular arc according to a positional relationship between the first tangent segment and the second tangent segment comprises:
determining that said circular arc is the target circular arc in response to the first tangent segment intersecting with the second tangent segment; and
determining that said circular arc is not the target circular arc in response to the first tangent segment not intersecting with the second tangent segment.

7. The method according to any one of claims 1 to 6, wherein replacing, in the route, the target circular arc with the new sub-route to adjust the route of the wire comprises:
removing the target circular arc, and generating a tangent segment connecting a preceding object and a succeeding object of the target circular arc, to adjust the route of the wire, where the preceding object is a circular arc immediately previous to the target circular arc along a direction from the first routing port to the second routing port among the at least one circular arc or is the first routing port, and the succeeding object isa circular arc immediately subsequent to the target circular arc along the direction among the at least one circular arc or is the second routing port.

8. The method according to any one of claims 1 to 7, wherein after replacing, in the route, the target circular arc with the new sub-route to adjust the route of the wire, the method further comprises:
determining whether there is the target circular arc among the at least one circular arc; and
terminating the routing to obtain an adjusted chip layout, in response to determining that there is no target circular arc among the at least one circular arc.

9. The method according to any one of claims 1 to 8, wherein obtaining the route of the wire extending from the first routing port of the chip layout to the second routing port of the chip layout comprises:
determining at least one vertex from vertices of one or more polygons representing one or more chip components, respectively, in the chip layout;
determining, for each of the at least one vertex, a respective circle centered at said vertex; and
determining an initial version of the route according to the first routing port, the second routing port, and the respective circle of each of the at least one vertex.

10. The method according to claim 9, wherein the at least one vertex is ordered in a sequence along the route in a direction from the first routing port to the second routing port, and determining the initial version of the route according to the first routing port, the second routing port, and the respective circle of each of the at least one vertex comprises:
determining a tangent, passing through the first routing port, of the respective circle of a head vertex of the at least one vertex in the sequence, and determining a point of the tangent passing through the first routing port contacting the respective circle of the head vertex as an initial point of tangency of the head vertex;
for each pair of adjacent vertices of the at least one vertex in the sequence, determining a common tangent between the respective circle of a vertex former in the sequence in said pair and the respective circle of a vertex latter in the sequence in said pair, determining a point of the common tangent contacting the respective circle of the former vertex as a terminal point of tangency of the former vertex, and determining a point of the common tangent contacting the respective circle of the latter vertex as an initial point of tangency of the latter vertex;
determining a tangent, passing through the second routing port, of the respective circle of a tail vertex of the at least one vertex in the sequence, and determining a point of the tangent passing through the second routing port contacting the respective circle of the tail vertex as a terminal point of tangency of the tail vertex;
for each vertex of the at least one vertex, determining a circular arc on the respective circle of said vertex from the initial point of tangency to the terminal point of tangency of said vertex as a respective circular arc of said vertex; and
connecting the at least one tangent segment and the at least one respective circular arc of the at least one vertex sequentially from the first routing port to the second routing port to obtain the initial version of the route.

11. The method according to claim 9 or 10, wherein determining, for each of the at least one vertex, the respective circle centered at the said vertex comprises:
determining a radius of the respective circle of said vertex according to a quantity of wires that have a detour for avoidance of said vertex, wherein:
the radius is equal to a shortest distance for safe routing in response to the quantity being equal to zero; the radius is equal to a sum of the shortest distance for safe routing and a product of a positive integer s and a space between adjacent routes, in response to the quantity being equal to s; and the shortest distance and the space are constants; and
determining the respective circle of said vertex according to the radius.

12. The method according to any one of claims 9 to 11, wherein determining the at least one vertex from vertices of one or more polygons representing one or more chip components, respectively, in the chip layout comprises:
determining a line segment connecting the first routing port and the second routing port to serve as an initial line segment, wherein the first routing port serves as a starting point of the initial line segment, and the second routing port serves an end point of the initial line segment; and
repeating iterations each of which comprises, for each initial line segment:
determining a vertex for said initial line segment according to distances from the vertices of the one or more polygons to said initial line segment;
determining the vertex for said initial line segment as an intermediate point, determining a first line segment connecting the intermediate point and the start point of said initial line segment, and determining a second line segment connecting the intermediate point and the end point of said initial line segment; and
determining each of the first line segment and the second line segment as new initial line segments that replace said initial segment;
until all initial line segments need to detour for avoidance of none of the vertices of the one or more polygons, wherein each initial line segment connects any two points among: the first routing port, the at least one determined vertex, and the second routing port.

13. A chip, manufactured based on a chip layout with routing obtained through the method according to any one of claims 1 to 12.

14. The chip according to claim 13, wherein the chip is a quantum chip.

15. An apparatus for routing on a chip layout, comprising:
a routing determining module, configured to obtain a route of a wire extending from a first routing port of the chip layout to a second routing port of the chip layout, wherein the route comprises at least one tangent segment and at least one circular arc that are alternately connected, for each of the at least one tangent segment, a straight line comprising said tangent segment is tangent to each circle comprising a circular arc, of the at least one circular arc, connected to said tangent segment, for each circular arc of the at least one circuit arcs, a respective vertex of the chip layout serves as a center of said circular arc, the vertex is of a polygon representing a chip component in the chip layout, and said circular arc forms a detour between the first routing port and the second routing port for avoidance of the chip component;
an arc determining module, configured to determine a target circular arc among the at least one circular arc, wherein the target circular arc is a circular arc introducing a loop into the route, and the circular arc introducing the loop into the route refers to that a central angle of the circular arc is greater than a threshold; and
a routing adjusting module, configured to replace, in the route, the target circular arc with a new sub-route to adjust the route of the wire.

16. A computer device, comprising a processor and a memory, wherein the memory stores a computer program, and the processor is configured to execute the computer program to implement the method according to any one of claims 1 to 12.

17. A computer-readable storage medium, storing a computer program, wherein the computer program when being loaded and executed by a processor is configured to implement the method according to any one of claims 1 to 12.

18. A computer program product, comprising a computer program, wherein the computer program when being loaded and executed by a processor is configured to implement the method according to any one of claims 1 to 12.
